# EUROPÄISCHE PATENTANMELDUNG

(11) **EP 1 338 617 A2**
(43) Veröffentlichungstag der Anmeldung: **27.08.2003**
(21) Anmeldenummer: 03002155.4
(22) Anmeldetag: 03.02.2003
(51) Int. Cl.: C08G 61/12

(54) **Transparente Polythiophenschichten hoher Leitfähigkeit**

(30) Priorität: 15.02.2002 DE 10206294
(71) Anmelder: Bayer Aktiengesellschaft, 51368 Leverkusen (DE)
(72) Erfinder: Kirchmeyer, Stephan, Dr., 51375 Leverkusen (DE); Jonas, Friedrich, Dr., 52066 Aachen (DE)

(57) **Zusammenfassung**

Verfahren zur Herstellung transparenter elektrisch leitfähiger Polythiophenschichten mit einer spezifischen Leitfähigkeit von mindestens 500 S/cm durch Polymerisation eines Thiophens oder eines Gemischs verschiedener Thiophene mittels chemischer Oxidation, wobei als Oxidationsmittel Eisen(III)salze alicylischer Sulfonsäuren eingesetzt werden, so erhältliche Schichten und deren Verwendung.

## Beschreibung

Die Erfindung betrifft ein Verfahren zur Herstellung transparenter elektrisch leitfähiger Schichten mit einer Leitfähigkeit von mindestens 500 S/cm, entsprechende Schichten und deren Verwendung.

Schichten aus Polythiophenen, ihre Herstellung durch elektrochemische oder chemische Oxidation geeigneter Thiophene und ihre Verwendung zur antistatischen Ausrüstung von den elektrischen Strom nicht oder nur schlecht leitenden Substraten sind bekannt.

In EP 206 133 A1 wird ein Verfahren zum Aufbringen von Schichten aus mit Hilfe von Oxidationsmitteln erzeugten leitfähigen, polymeren, heterocyclischen Verbindungen auf den Strom nicht oder schlecht leitenden Substraten beschrieben. Die Leitfähigkeiten der gemäß EP 206 133 A1 herstellbaren Polymeren betragen maximal 100 S/cm.

In EP 253 594 A2 sind spezielle in 3-und/oder 4-Stellung durch gegebenenfalls substituierte Alkyl- und/oder Alkoxy-Gruppen substituierte Thiophene und die aus ihnen durch chemische oder elektrochemische Oxidation erhaltenen elektrisch leitfähigen Polymeren beschrieben. Die in EP 253 594 A2 beschriebenen Polymere bzw. Copolymere, die auf dem Wege der chemischen Oxidation hergestellt werden, haben nur Leitfähigkeiten bis zu 0,05 S/cm. Werden die Polymere bzw. Copolymere auf dem Wege der elektrochemischen Oxidation hergestellt, können Leitfähigkeiten bis zu 1050 S/cm erreicht werden. Nachteil einer elektrochemischen Oxidation ist jedoch, dass dieses Vorgehen im Vergleich zur chemischen Oxidation aufgrund der benötigten Vorrichtung deutlich aufwendiger ist. Darüber hinaus sind die mittels elektrochemischer Oxidation gewonnenen Polymere weitgehend unlöslich, was deren Einsatzmöglichkeiten stark beschränkt. Homogene Polymerfilme lassen sich durch elektrochemische Oxidation in der Regel nur bis zu einer Schichtdicke von etwa 200 nm erhalten, sie weisen überdies nur eine geringe mechanische Festigkeit auf und sind sehr rauh.

US-A-4 521 589 beschreibt die Herstellung von polymeren 3-Alkyl-thiophenen durch Umsetzung von 3-Alkyl-2,5-dihalogen-thiophenen mit Magnesium in Gegenwart von Nickelverbindungen in inerten organischen Lösungsmitteln. Die elektrische Leitfähigkeit der auf diese Weise erhaltenen Polythiophene wird mit 9 x 10⁻¹⁴ S/cm angegeben. Durch Umsetzung mit Iod kann die Leitfähigkeit auf etwa 0,5 S/cm gesteigert werden.

EP 203 438 A1 und EP 257 573 A1 beschreiben die Herstellung von in organischen Lösungsmitteln löslichen substituierten leitfähigen Polythiophenen und die Verwendung der Lösungen dieser löslichen Polythiophene zur antistatischen Ausrüstung von den elektrischen Strom nicht oder nur schlecht leitenden Substraten. Die Leitfähigkeiten der in EP 203 438 A1 beschriebenen Polythiophene betragen vorzugsweise mehr als 10⁻² S/cm, wobei solche Leitfähigkeiten erst nach Dotierung der Polymere mit Elektronendonatoren, beispielsweise Jod, erhalten werden können. Auch nach Dotierung werden nur Leitfähigkeiten von maximal 15 S/cm beschrieben. Gemäß EP 257 573 A1 sind Polythiophene durch elektrochemische Polymerisation mit Leitfähigkeiten mit bis zu 100 S/cm herstellbar.

EP 339 340 A2 beschreibt 3,4-substituierte Polythiophene, die durch oxidative Polymerisation der entsprechenden Thiophene hergestellt werden können. Als Oxidationsmittel werden unter anderem Eisen(III)salze organischer Säuren bzw. organische Reste tragender anorganischer Säuren beschrieben. Beispielsweise werden Eisen(III)salze von C₁-C₂₀-Alkylsulfonsäuren und von aromatischen Sulfonsäuren genannt. Die aus den Polythiophenen herstellbaren Schichten weisen Leitfähigkeiten von lediglich 0,01 bis 10 S/cm auf. Auch hier können die Leitfähigkeiten bis auf 200 S/cm erhöht werden, wenn nicht chemisch, sondern elektrochemisch oxidiert wird. Die damit verbundenen Nachteile sind bereits oben beschrieben.

EP 820 076 A2 beschreibt Kondensatoren mit Feststoffelektrolyten aus elektrisch leitfähigen Polymeren. Die Feststoffelektrolyte bestehen aus Polymeren von Pyrrolen, Thiophenen, Furanen, Anilinen oder deren Derivaten, die mit Polysulfonsäuren, organischen Sulfonsäuren mit Hydroxylgruppen oder Carboxylgruppen, alicyclischen Sulfonsäuren oder einer Benzochinon-Sulfonsäure dotiert sind. EP 820 076 A2 beschreibt die Tränkung von Tantalfolien hoher Oberfläche, die das Licht streut. Die in EP 820 076 A2 beschriebenen Feststoffelektrolyte sind daher nicht transparent, sondern opak. Es gibt keinen Hinweis darauf, dass die in EP 820 076 A2 beschriebenen Feststoffelektrolyte eine besondere Leitfähigkeit aufweisen. Leitfähigkeiten von 10 bis 100 S/cm sind laut EP 820 076 A2 für die Anwendung einer Polymerschicht als Feststoffelektrolyt ausreichend. Auf die Herstellung von Polymerschichten mit höherer Leitfähigkeit wird nicht eingegangen.

Für eine Vielzahl von Anwendungen ist aber gerade eine besonders hohe Leitfähigkeit notwendig, so dass die Aufgabe der vorliegenden Erfindung darin besteht, elektrisch leitfähige Schichten mit einer besonders hohen Leitfähigkeit zur Verfügung zu stellen, die sich überdies durch eine hohe Transparenz auszeichnen.

Überraschenderweise wurde gefunden, dass man transparente elektrisch leitfähige Schichten besonders hoher Leitfähigkeit unter Verwendung von Polymeren herstellen kann, die man durch chemische Oxidation geeigneter Thiophene herstellt, wobei man als Oxidationsmittel Eisen(III)salze von alicyclischen Sulfonsäuren verwendet.

Die Erfindung betrifft daher ein Verfahren zur Herstellung transparenter elektrisch leitfähiger Schichten, mit einer Leitfähigkeit von größer 500 S/cm durch Polymerisation ein oder mehrerer Thiophene der allgemeinen Formel (I) 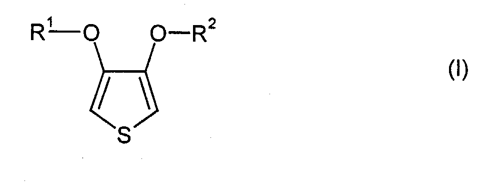 in der
- R¹ und R²: unabhängig voneinander für einen gegebenenfalls substituierten linearen oder verzweigten Alkylrest, Aryl-, Alkylaryl- oder einen heterocyclischen Rest mit 1 bis 10 Kohlenstoffatomen,
oder R¹ und R² zusammen einen linearen oder verzweigten substituierten oder unsubstituierten Alkylenrest mit 1 bis 18 Kohlenstoffatomen bedeuten,
wobei die Polymerisation durch chemische Oxidation durchgeführt wird und als Oxidationsmittel Eisen(III)salze alicylischer Sulfonsäuren eingesetzt werden.

Bevorzugt stehen R¹ und R² unabhängig voneinander für einen linearen oder verzweigten Alkylrest mit 1 bis 6 Kohlenstoffatomen, C₆-C₁₀-Aryl oder C₁-C₆-Alkyl-C₆-C₁₀-aryl oder R¹ und R² zusammen für einen linearen gegebenenfalls substituierten Alkylenrest mit 1 bis 10 Kohlenstoffatomen.

Die Erfindung betrifft weiterhin die so erhältlichen Schichten und die Verwendung dieser elekrisch leitfähigen Schichten.

Vorzugsweise werden in dem erfindungsgemäßen Verfahren Verbindungen der allgemeinen Formel (II) 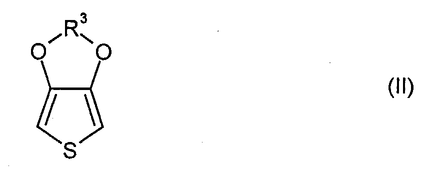 in der
- R³: für -(CH₂)ₘ-CR⁴R⁵-(CH₂)ₙ- steht, wobei
- R⁴ und R⁵: gleich oder verschieden für Wasserstoff, einen linearen oder verzweigten Alkylrest mit 1 bis 18 Kohlenstoffatomen, OH, O-CH₂-CH₂-CH₂-SO₃H oder O-Alkyl mit 1-18 Kohlenstoffatomen und
- n und m: jeweils unabhängig voneinander für eine ganze Zahl von 0 bis 9 stehen, wobei die Summe n + m ≤ 9 ist,
verwendet.

Bevorzugt stehen R⁴ und R⁵ unabhängig voneinander für Wasserstoff, einen linearen Alkylrest mit 1 bis 6 Kohlenstoffatomen, OH, O-CH₂-CH₂-CH₂-SO₃H oder O-Alkyl mit 1 bis 6 Kohlenstoffatomen. Insbesondere bevorzugt stehen R⁴ und R⁵ für Wasserstoff.

Beispiele für im erfindungsgemäßen Verfahren einsetzbare Verbindungen sind z.B. Dimethoxythiophen, Diethoxythiophen, Dipropoxythiophen, Dibutoxythiophen, Methylendioxthiophen, Ethylendioxythiophen, Propylendioxythiophen, Butylendioxythiophen, mit Hydroxy- bzw. Alkoxygruppen substituierte Thiophene, wie sie beispielsweise in US-A-5 111 327 beschrieben werden, CH₂-O-(CH₂)ₙ-SO₃H-Gruppen tragende Thiophene, wobei n für eine ganze Zahl von 2 bis 10 steht, und mit einer Alkylgruppe, vorzugsweise C₁-C₁₀-Alkyl, substituierte Ethylendioxythiophene.

Die im erfindungsgemäßen Verfahren einsetzbaren Eisen(III)salze sind Eisen(III)-salze alicyclischer Sulfonsäuren. Die den Eisen(III)salzen zugrundeliegenden Sulfonsäuren sind Sulfonsäuren, die einen alicyclischen Ring mit 4 bis 20 Kohlenstoffatomen und eine oder mehrere Sulfonsäuregruppen enthalten.

Beispiele für im erfindungsgemäßen Verfahren einsetzbare alicyclische Sulfonsäuren sind: Cyclohexan-Sulfonsäure, Methylcyclohexansulfonsäure, Cycloheptan-Sulfonsäure, Camphersulfonsäure und Sulfonsäuren, die z.B. durch Hydrierung von aromatischen Sulfonsäuren herstellbar sind.

Bevorzugt einsetzbar sind im erfindungsgemäßen Verfahren Eisen(III)salze der Camphersulfonsäure, wobei Eisen(III)(+)camphersulfonat, Eisen(III)(-)camphersulfonat, das Racemat aus Eisen(III)(+)camphersulfonat und Eisen(III)(-)camphersulfonat oder beliebige Gemische aus Eisen(III)(+)camphersulfonat und Eisen(III)(-)camphersulfonat verwendet werden können.

Der Zusatz weiterer Oxidationsmittel und/oder von Dotierungsmitteln ist nicht notwendig und wird vorzugsweise vermieden.

Bei der Durchführung des erfindungsgemäßen Verfahrens entstehen elektrisch leitfähige, transparente Schichten, die Polythiophene mit positiven Ladungen in der Polymerkette und diese Ladung kompensierende Gegenionen enthalten. In vereinfachter und schematischer Weise können die in den nach dem erfindungsgemäßen Verfahren herstellbaren Schichten enthaltenen Polymere durch Formel (III) veranschaulicht werden, 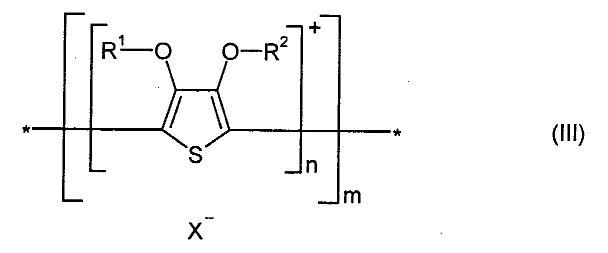 wobei
- R¹ und R²: die oben angegebene Bedeutung haben,
- X-: das entsprechende Sulfonation des im erfindungsgemäßen Verfahren eingesetzten Eisen(III)salzes einer alicyclischen Sulfonsäure und
- n: im Mittel Zahlen von 1 bis 20 und m im Mittel Zahlen von 2 bis 10000 bedeuten.

Die oxidative Polymerisation der Thiophene gemäß Formel I und II durch chemische Oxidation kann je nach gewünschter Reaktionszeit im allgemeinen bei Temperaturen von -10 bis +250°C, bevorzugt bei Temperaturen von 0 bis 200°C vorgenommen werden.

Es wird dem einzusetzenden Thiophen häufig ein unter den Reaktionsbedingungen inertes organisches Lösungsmittel zugegeben und so eine Beschichtungslösung erhalten, die auf ein Substrat aufgebracht werden kann. Als inerte organische Lösungsmittel seien vor allem genannt: aliphatische Alkohole wie Methanol, Ethanol und Propanol; aliphatische Ketone wie Aceton und Methylethylketon; aliphatische Carbonsäureester wie Essigsäureethylester und Essigsäurebutylester; aromatische Kohlenwasserstoffe wie Toluol und Xylol; aliphatische Kohlenwasserstoffe wie Hexan, Heptan und Cyclohexan; Chlorkohlenwasserstoffe wie Dichlormethan und Dichlorethan; aliphatische Nitrile wie Acetonitril; aliphatische Sulfoxide und Sulfone wie Dimethylsulfoxid und Sulfolan; aliphatische Carbonsäureamide wie Dimethylacetamid, Dimethylformamid und N-Methylpyrrolidon; aliphatische und araliphatische Ether wie Diethylether und Anisol. Weiterhin kann auch Wasser oder Gemische aus Wasser mit den vorgenannten organischen Lösungsmitteln, sofern diese mit Wasser mischbar sind, als Lösungsmittel verwendet werden.

Die oxidative Polymerisation der Thiophene der Formeln I und II erfordert theoretisch je Mol Thiophen 2,25 Äquivalente Oxidationsmittel (siehe z.B. J. Polym. Sc. Part A, Polymer Chemistry Vol. 26, S. 1287 (1988)). Praktisch wird das Oxidationsmittel jedoch in einem gewissen Überschuss, z.B. einem Überschuss von 0,1 bis 2 Äquivalenten je Mol Thiophen angewendet.

Die Herstellung der transparenten, elektrisch leitfähigen Schichten kann durch gemeinsame oder getrennte Aufbringung von Thiophen und Oxidationsmittel erfolgen.

Für die getrennte Aufbringung wird in der Regel ein zu beschichtendes Substrat zunächst mit der Lösung des Oxidationsmittels und anschließend mit der Lösung des Thiophens behandelt. Bei gemeinsamer Aufbringung von Thiophen und Oxidationsmitteln wird in der Regel ein zu beschichtendes Substrat nur mit einer Thiophen und Oxidationsmittel enthaltenden Lösung beschichtet. Da bei einem gemeinsamen Aufbringen ein Teil des Thiophens verdunstet, versetzt man die Lösungen mit einer dem zu erwartenden Thiophenen-Verlust entsprechend geringeren Oxidationsmittel-Menge.

Vor Herstellung der Beschichtungen können den Beschichtungslösungen Bindemittel und/oder Vernetzer wie Polyurethane, Polyacrylate, Polyolefine, Epoxisilane, wie 3-Glycidoxypropyltrialkoxysilan, zugesetzt werden. Weiterhin können Silane oder Silanhydrolysate z.B. auf Basis von Tetraethoxysilan zur Erhöhung der Kratzfestigkeit bei Beschichtungen zugesetzt werden.

Die auf die zu beschichtenden Substrate aufzubringenden Beschichtungslösungen enthalten vorzugsweise 1 bis 30 Gewichts-% des entsprechenden Thiophens der Formel I und/oder II und 0 bis 30 Gewichts-% Bindemittel, beide Gewichts-Prozente bezogen auf das Gesamtgewicht der Lösung. Die Beschichtungslösungen können nach bekannten Verfahren, z.B. durch Sprühen, Rakeln, durch Spin-Coating, Streichen oder Bedrucken auf die Substrate aufgebracht werden.

Nach dem Aufbringen der Beschichtungslösungen kann das Lösungsmittel durch einfaches Abdampfen bei Raumtemperatur entfernt werden. Zur Erzielung höherer Verarbeitungsgeschwindigkeiten ist es jedoch vorteilhaft, die Lösungsmittel bei erhöhten Temperaturen, z.B. bei Temperaturen von 20 bis zu 250°C, bevorzugt 40 bis zu 200°C, zu entfernen.

Das Entfernen der Lösungsmittel bei erhöhter Temperatur ist auch deshalb vorteilhaft, weil gefunden wurde, dass sich die elektrische Leitfähigkeit der erfindungsgemäßen Schichten durch eine Temperatur-Behandlung der Beschichtung bei Temperaturen von 50 bis 250°C, vorzugsweise von 100 bis 200°C, erhöhen lässt. Die thermische Nachbehandlung kann unmittelbar nach dem Entfernen des Lösungsmittels aber auch in zeitlichem Abstand von der Fertigstellung der Beschichtung vorgenommen werden.

Nach dem Entfernen der Lösungsmitteln (Trocknen) kann es vorteilhaft sein, das überschüssige Oxidationsmittel aus der Beschichtung auszuwaschen. Hierfür eignet sich Wasser, ggf. im Gemisch mit organischen Sulfonsäuren, oder niedere Alkohole wie z.B. Methanol und Ethanol.

Als Substrate, die nach dem erfindungsgemäßen Verfahren beschichtet werden können, seien vor allem anorganische transparente Substrate aus Glas, Siliziumdioxid und keramischen Werkstoffen und flächige transparente Substrate aus organischen Kunststoffen, z.B. transparente Folien aus Polycarbonat, Polyamid, Polyolefinen, Polyestern genannt. Die Substrate können ggf. vor der eigentlichen Beschichtung z.B. zur Erzeugung einer besseren Haftung mit Haftvermittler wie z.B. Silanen beschichtet werden.

Die Schichtdicke der aufgebrachten Beschichtung nach dem Trocknen beträgt in Abhängigkeit von der gewünschten Leitfähigkeit und der gewünschten Transparenz der Beschichtung im allgemeinen 0,01 bis 100 µm.

Die nach dem erfindungsgemäßen Verfahren herstellbaren transparenten elektrisch leitfähigen Schichten weisen eine spezifische elektrische Leitfähigkeit von mindestens 500 S/cm, vorzugsweise eine spezifische elektrische Leitfähigkeit von mindestens 1000 S/cm auf. Die spezifische Leitfähigkeit wird durch Messung der Schichtdicke mittels Profilometer und Messung des Oberflächenwiderstandes (Messstreifen 2 x 2 cm, Widerstandsmessung mittels eines handelsüblichen Widerstandsmessgerätes) bzw. mittels handelsüblichem Vierpunktmessgerät bestimmt.

Die Schichten weisen eine hohe optische Transparenz auf. Vorzugsweise beträgt die optische Transparenz mindestens 50 %, besonders bevorzugt mindestens 75 %. Die optische Transparenz wird dabei mittels Transmissionsmessung mit einem handelsüblichen UV-Vis-Spektrometer im Bereich des sichtbaren Lichtes (300-800 nm) und Bildung des Zahlenmittels aus mindestens drei Einzelwerten bestimmt.

Gegenstand der Erfindung sind weiterhin transparente leitfähige Schichten, die nach dem erfindungsgemäßen Verfahren erhältlich sind.

Die erfindungsgemäßen elektrisch leitfähigen, transparenten Schichten eignen sich z.B. zur Ausrüstung von Kunststofffolien für die Verpackung elektronischer Bauteile und für Reinraumverpackungen, zur antistatischen Ausrüstung von Kathodenstrahlröhren, zur antistatischen Ausrüstung von photographischen Filmen, als transparente Heizung, als transparente Elektroden, Leiterplatten oder von elektrisch einfärbbaren Fensterscheiben.

### Beispiele

Spezifische Leitfähigkeiten wurden durch Messung der Schichtdicke (Profilometer) und Messung des Oberflächenwiderstandes (Messstreifen 2 x 2 cm, Widerstandsmessung mittels handelsüblichem Widerstandsmessgerät) bzw. mittels handelsüblichem Vierpunktmessgerät bestimmt.

### Beispiel 1

0,25 g Ethylen-3,4-dioxythiophen (1,76 mmol) und 5,0 g (13,3 mmol) einer 54 Gew.proz. Eisen(III)camphersulfonat-Lösung in Butanol wurden ineinander gelöst und auf Glasplatten mit Hilfe eines handelsüblichen Spincoaters bei verschiedenen Umdrehungsgeschwindigkeiten aufgebracht. Die beschichteten Glasplatten wurden bei Raumtemperatur getrocknet und eine Stunde bei 80°C nachgetempert. Nach Abkühlung der Glasplatten wurden die Glasplatten mit Wasser gewaschen und getrocknet. Die Schichtdicken und spezifischen Leitfähigkeiten sind in Tabelle 1 dargestellt.

**Tabelle 1**

| **Umdrehungszahl** | **Spezifische Leitfähigkeit in S/cm** | **Schichtdicke in nm** |
|---|---|---|
| 1500 | 1035 | 420 |
| 2000 | 1276 | 340 |

### Vergleichsbeispiel 1

0,25 g Ethylendioxthiophen (1,76 mmol) und 5,0 g (3,80 mmol) einer 40 Gew.-% Eisen(III)-p-toluolsulfonsäure-Lösung in Butanol wurden ineinander gelöst und auf Glasplatten mit Hilfe eines handelsüblichen Spincoaters bei verschiedenen Umdrehungsgeschwindigkeiten aufgebracht. Die beschichteten Glasplatten wurden bei Raumtemperatur getrocknet und eine Stunde bei 80°C nachgetempert. Nach Abkühlung der Glasplatten wurden die Glasplatten mit Wasser gewaschen und getrocknet. Die Schichtdicken und spezifischen Leitfähigkeiten sind in Tabelle 2 dargestellt.

**Tabelle 2**

| **Umdrehungszahl** | **Spezifische Leitfähigkeit in S/cm** | **Schichtdicke in nm** |
|---|---|---|
| 500 | 119 | 380 |
| 1000 | 122 | 240 |

### Vergleichsbeispiel 2

0,25 g Ethylendioxthiophen (1,76 mmol) und 5,0 g (3,80 mmol) einer 43,6 proz. Eisen(III)-phenol-4-sulfonsäure-Lösung in Butanol wurden ineinander gelöst und auf eine Glasplatte mit Hilfe eines handelsüblichen Spincoaters aufgebracht. Die Glasplatte wurde bei Raumtemperatur getrocknet und eine Stunde bei 80°C nachgetempert. Nach Abkühlung der Glasplatte wurde die Glasplatte mit Wasser gewaschen und getrocknet. Die Schichtdicke und spezifische Leitfähigkeit sind in Tabelle 3 dargestellt.

**Tabelle 3**

| **Umdrehungszahl** | **Spezifische Leitfähigkeit in S/cm** | **Schichtdicke in nm** |
|---|---|---|
| 500 | 2,5 | 1300 |

### Vergleichsbeispiel 3

0,25 g Ethylendioxthiophen (1,76 mmol) und 5,0 g (3,80 mmol) einer 25,9 proz. Eisen(III)-methansulfonsäure-Lösung in Butanol wurden ineinander gelöst und auf eine Glasplatte mit Hilfe eines handelsüblichen Spincoaters aufgebracht. Die beschichtete Glasplatte wurde bei Raumtemperatur getrocknet und eine Stunde bei 80°C nachgetempert. Nach Abkühlung der Glasplatte wurde die Glasplatte mit Wasser gewaschen und getrocknet. Die Schichtdicke und spezifische Leitfähigkeit sind in Tabelle 4 dargestellt.

**Tabelle 4**

| **Umdrehungszahl** | **Spezifische Leitfähigkeit in S/cm** | **Schichtdicke in nm** |
|---|---|---|
| 500 | 102 | 1300 |

## Patentansprüche

1. Verfahren zur Herstellung transparenter elektrisch leitfähiger Schichten mit einer spezifischen Leitfähigkeit von mindestens 500 S/cm durch Polymerisation eines Thiophens der allgemeinen Formel (I) oder eines Gemisches verschiedener Thiophene der Formel (I) 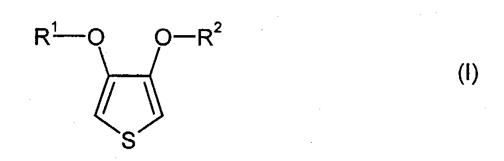 in der
R¹ und R² unabhängig voneinander für einen gegebenenfalls substituierten linearen oder verzweigten Alkylrest, Aryl-, Alkylaryl- oder einen heterocyclischen Rest mit 1 bis 10 Kohlenstoffatomen,
oder R¹ und R² zusammen einen linearen oder verzweigten substituierten oder unsubstituierten Alkylenrest mit 1 bis 18 Kohlenstoffatomen bedeuten,
**dadurch gekennzeichnet, dass** die Polymerisation durch chemische Oxidation durchgeführt wird, wobei als Oxidationsmittel Eisen(III)salze alicylischer Sulfonsäuren eingesetzt werden.

2. Verfahren zur Herstellung transparenter elektrisch leitfähiger Schichten gemäß Anspruch 1, **dadurch gekennzeichnet, dass** als Thiophen eine Verbindung der Formel (II) 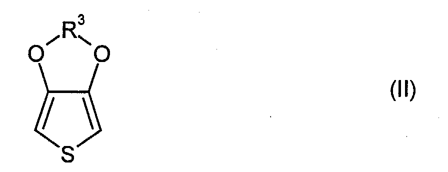 in der
R³ für -(CH₂)ₘ-CR⁴R⁵-(CH₂)ₙ- steht, wobei
R⁴ und R⁵ unabhängig voneinander für Wasserstoff, einen linearen oder verzweigten Alkylrest mit 1 bis 18 Kohlenstoffatomen, OH, O-CH₂-CH₂-CH₂-SO₃H oder O-Alkyl mit 1 bis 18 Kohlenstoffatomen und
n und m jeweils unabhängig voneinander für eine ganze Zahl von 0 bis 9 stehen, wobei die Summe n + m ≤ 9 ist,
verwendet wird.

3. Verfahren zur Herstellung transparenter elektrisch leitfähiger Schichten gemäß Anspruch 1 und 2, **dadurch gekennzeichnet dass** als Thiophen 3,4-Ethylendioxythiophen verwendet wird.

4. Verfahren zur Herstellung transparenter elektrisch leitfähiger Schichten gemäß Anspruch 1 bis 3, **dadurch gekennzeichnet, dass** als Eisen(III)salz Eisen(III)camphersulfonat verwendet wird.

5. Verfahren zur Herstellung transparenter elektrisch leitfähiger Schichten gemäß Anspruch 1 bis 4, **dadurch gekennzeichnet, dass** die Transparenz der leitfähigen Schichten mindestens 50 Prozent beträgt.

6. Verfahren zur Herstellung transparenter elektrisch leitfähiger Schichten gemäß Anspruch 1 bis 5, **dadurch gekennzeichnet, dass** die spezifische Leitfähigkeit der transparenten elektrisch leitfähigen Schichten mindestens 1000 S/cm beträgt.

7. Elektrisch leitfähige Schicht erhältlich durch ein Verfahren gemäß wenigstens eines der Ansprüche 1 bis 6.

8. Verwendung von elektrisch leitfähigen Schichten gemäß Anspruch 7 zur Ausrüstung von Kunststofffolien für die Verpackung elektronischer Bauteile und für Reinraumverpackungen, antistatische Ausrüstung von Kathodenstrahlröhren, antistatische Ausrüstung von photographischen Filmen, als transparente Heizung, als transparente Elektroden, Leiterplatten oder von elektrisch einfärbbaren Fensterscheiben.
